# EUROPEAN PATENT APPLICATION

(11) **EP 0 522 532 A2**
(43) Date of publication of application: **13.01.1993**
(21) Application number: 92111584.6
(22) Date of filing: 08.07.1992
(51) Int. Cl.: H01L 21/321

(54) **Method for etching aluminium or aluminiums-alloys in the manufacture of semi-conductor devices**

(30) Priority: 09.07.1991 JP 168391/91
(71) Applicant: SEMICONDUCTOR PROCESS LABORATORY CO., LTD., Minato-ku, Tokyo 108 (JP); ALCAN- TECH CO., INC., Tokyo (JP); CANON SALES CO., INC., Minato-ku, Tokyo 108 (JP)
(72) Inventor: Oku, Taizo, Tokyo (JP); Yamamoto, Jin, Minato-ku, Tokyo (JP); Fujino, Katsuhiro, c/o Semiconductor Process, Minato-ku, Tokyo (JP)
(74) Representative: Schwabe - Sandmair - Marx

(57) **Abstract**

The present invention relates to a method for etching one of aluminum and aluminum alloy in a manufacturing process of a semiconductor device, and it is an object of the present invention to provide a method for manufacturing a semiconductor device in which no dust is generated, the selection ratio to SiO₂ and resist is high, and furthermore, it is made possible to perform patterning of one of aluminum and aluminum alloy with high accuracy.

One of aluminum and aluminum alloy is etched by means of gas obtained by mixing gas of chlorine interrelated group and gas of bromine interrelated group, and the mixed gas is one of mixed gas of Cℓ₂, BCℓ₃ and HBr, mixed gas of Cℓ₂, BCℓ₃ and BBr₃, mixed gas of Cℓ₂ and BBr₃ and mixed gas of BCℓ₃ and HBr. Further, one of aluminum and aluminum alloy is etched by mixed gas of HBr and BBr₃.

## Description

### BACKGROUND OF THE INVENTION

The present invention relates to a method for manufacturing a semiconductor device, and more particularly to a method for etching one of aluminum and aluminum alloy in a manufacturing process of a semiconductor device.

As a semiconductor device is densified and highly integrated, it is demanded in recent years to form a very fine wiring pattern by etching aluminum with high accuracy. As a result, research and development of anisotropic dry etching advantageous for forming a very fine pattern are being carried out extensively in addition to anisotropic wet etching.

As a conventional method for applying anisotropic etching to aluminum and aluminum alloy, it is well known to use gas of Cℓ₂ interrelated group and apply etching by high frequency (RF) plasma.

For example, Cℓ₂ gas, BCℓ₃ gas or mixed gas of Cℓ₂ and BCℓ₃ is used are the gas of chlorine interrelated group. When such of Cℓ₂ interrelated group is used, however, aluminum and aluminum alloy after removing aluminum oxide which covers the surface thereof are etched even at the indoor temperature. Therefore, side etching proceeds easily. As a result, a problem that the etching accuracy of an aluminum pattern is substantially deteriorated is posed.

Accordingly, side etching is prevented by using such gas that forms a film for protecting an etching surface during etching of one of aluminum and aluminum alloy. As such gas, mixed gas of Cℓ₂, BCℓ₃ and SiCℓ₄ or mixed gas of Cℓ₂, BCℓ₃ and CHCℓ₃ are available. According to this method, the sidewall of one of aluminum and aluminum alloy is protected by a protective film. Thus, side etching is prevented, and a highly accurate pattern is obtainable.

According to an etching method using such gas, however, there is such a problem that dust is generated during etching, and normal patterning is disturbed by the dust. Further, it is demanded that a selection ratio of one of aluminum and aluminum alloy to SiO₂ which forms the substrate thereof and resist which becomes an etching mask is large (the difference between etching rates is large).

It is an object of the present invention to provide a method for manufacturing a semiconductor device in which a selection ratio of SiO₂ and resist is high, side etching is very little, and patterning can be applied to aluminum and aluminum alloy with high accuracy.

Further, it is another object of the present invention to provide a method for manufacturing a semiconductor device which is able to improve production efficiency by a high etching rate while generating no dust during etching, and to prevent contamination of wafers and the inside of an etching apparatus.

### SUMMARY OF THE INVENTION

In a method for manufacturing a semiconductor device according to the present invention, one of aluminum and aluminum alloy is etched by gas obtained by mixing gas of chlorine interrelated group and gas of bromine interrelated group with each other.

For example, either mixed gas of Cℓ₂, BCℓ₃ and HBr or mixed gas of Cℓ₂, BCℓ₃ and BBr₃ may be used. Further, either mixed gas of Cℓ₂ and BBr₃ or mixed gas of HBr and BCℓ₃ may also be used.

Furthermore, in a method for manufacturing a semiconductor device according to the present invention, one of aluminum and aluminum alloy is etched by mixed gas of HBr and BBr₃.

The inventor of the present application has recognized as a result of experiment and study on aluminum and aluminum alloy using variety of gases that the best result is obtainable in case of those gases combined as follows.
① mixed gas of Cℓ₂, BCℓ₃ and HBr,
② mixed gas of Cℓ₂, BCℓ₃ and BBr₃,
③ mixed gas of Cℓ₂ and BBr₃, and
④ mixed gas of BBr₃ and HBr.

A cathode coupling type plasma etching apparatus of 13.56 MHz is used as the etching apparatus.

As the result of etching aluminum and aluminum alloy using these mixed gases, the followings have been noticed.
① Generation of dust during etching is very little. (Dust is generated because gas for forming a protective film such as SiCℓ₄ and CHCℓ₃ is used according to a conventional method).
② The accuracy of line/space is improved, thus making it possible to form a very fine pattern.
③ A selection ratio of SiO₂ of the substrate and resist of the mask to aluminum and aluminum alloy is high.

### DESCRIPTION OF THE PREFERRED EMBODIMENTS

In the next place, embodiments of the present invention will be described.

### (1) The first embodiment of the present invention

### - Production of a sample to be etched -

A SiO₂ film was formed on a Si substrate (wafer), and an Aℓ film having a film thickness of 1 µm containing Si at 1% was formed on the SiO₂ film as a film to be etched. Thereafter, a resist film was formed on the Aℓ film, and a pattern having several types of line/space width was formed on the resist film. Namely, a pattern in which the line/space width was increased at intervals of 0.2 µm to 0.1 µm was formed so as to produce a sample.

### - Etching -

Next, after putting the wafer in a plasma ion etching apparatus, plasma etching was applied under the following conditions. That is, gas obtained by mixing Cℓ₂ gas at 75 SCCM, BCℓ₃ gas at 75 SCCM and HBr gas at 75 SCCM was introduced into a cathode coupling type plasma ion etching apparatus, and etching was applied after setting the gas pressure in the apparatus to 0.11 Torr, the RF electric power of 13.56 Hz to 250 W (with d.c. bias at 350 V) and the wafer substrate temperature to 20°C.

### - Result of etching -

The etching rate of the Aℓ film was 2.2 µm/min., and a satisfactory result of 10 for the resist film and 40 for the SiO₂ film was obtainable as to the selection ratio. Further, an appropriate etching pattern of the Aℓ film was obtainable up to the line/space width of the resist film at 0.5 µm. Furthermore, generation of dust was not noticed during etching. With this, stabilized etching can be performed at all times.

### (2) The second embodiment of the present invention

### - Production and etching of a sample to be etched -

The etching conditions in the second embodiment are such that the gas pressure in the plasma etching apparatus is at 0.11 Torr, the RF electric power having a frequency of 13.56 MHz is at 250 W (with d.c. bias at 350 V), and the substrate temperature is at 20°C, which are the same as those in the first embodiment. Further, the sample to be etched is also similar to that used in the first embodiment.

What differs from the first embodiment in the etching conditions in the second embodiment exists in the etching gas. Namely, gas obtained by mixing Cℓ₂ gas at 75 SCCM, BCℓ₃ gas at 75 SCCM and BBr₃ gas at 75 SCCM is used as the etching gas in the second embodiment.

### - Result of etching -

The result similar to the embodiment 1 was obtainable. Namely, the etching rate of the Aℓ film was at 2.2 µm/min., and a satisfactory result of 10 for the resist film and 40 for the SiO₂ film was obtainable as to the selection ratio. Further, an appropriate etching pattern of an Aℓ film was obtained up to the width of line/space of the resist film at 0.5 µm. Further, generation of dust was not noticed during etching. With this, stabilized etching can be performed at all times.

### (3) The third embodiment of the present invention

### - Production and etching of a sample to be etched -

The etching conditions in the third embodiment are such that the gas pressure in the plasma etching apparatus is at 0.11 Torr, the RF electric power having a frequency of 13.56 MHz is at 250 W (with d.c. bias at 350 V), and the substrate temperature is at 20°C, which are the same as those in the first embodiment. Further, the sample to be etched is also similar to that in the first embodiment.

What differs from the first embodiment in the etching conditions in the third embodiment is the etching gas. Namely, gas obtained by mixing Cℓ₂ gas at 75 SCCM and BBr₃ gas at 25 SCCM is used as the etching gas.

### - Result of etching -

The following results were obtained. Namely, the etching rate of the Aℓ film was at 2.7 µm/min., and a satisfactory result of 15 for the resist film and 100 for the SiO₂ film was obtainable as to the selection ratio. Further, an appropriate etching pattern of an Aℓ film was obtainable up to the width of line/space of the resist film at 0.5 µm. Further, generation of dust was not noticed during etching. With this, stabilized etching can be performed at all times.

### (4) The fourth embodiment of the present invention

### - Production and etching of a sample to be etched -

The etching conditions of the fourth embodiment are such that the gas pressure in the plasma etching apparatus is at 0.11 Torr, the RF electric power having a frequency of 13.56 MHz is at 250 W (with d.c. bias at 350 V), and the substrate temperature is at 20°C, which are the same as those in the first embodiment. Further, the sample to be etched is also similar to that in the first embodiment.

What differs from the first embodiment in the etching conditions in the fourth embodiment is the etching gas. Namely, in the fourth embodiment, gas obtained by mixing HBr gas at 75 SCCM and BCℓ₃ gas at 75 SCCM is used as the etching gas.

### - Result of etching -

The following result was obtained. Namely, the etching rate of the Aℓ film was at 0.88 µm/min., and a satisfactory result of 6.3 for the resist film and 18.6 for the SiO₂ film were obtainable as to the selection ratio. Further, an appropriate etching pattern of the Aℓ film was obtainable up to the width of line/space of the resist film at 0.5 µm. Furthermore, generation of dust was not noticed during etching. With this, stabilized etching can be performed at all times.

### (5) The fifth embodiment of the present invention

### - Production and etching of a sample to be etched -

The etching conditions in the fifth embodiment are such that the gas pressure in the plasma etching apparatus is at 0.11 Torr, the RF electric power having a frequency of 13.56 MHz is at 250 W (with d.c. bias at 350 V), and the substrate temperature is at 20°C, which are the same as those in the first embodiment. Further, the sample to be etched is also similar to that in the first embodiment.

What differs from the first embodiment in the etching conditions in the fifth embodiment is the etching gas. Namely, in the fifth embodiment, gas obtained by mixing HBr gas at 75 SCCM and BBr₃ gas at 25 SCCM is used as the etching gas.

### - Result of etching -

As a result, the following result is obtainable. Namely, the etching rate of the Aℓ film was at 1.2 µm/min., and a satisfactory result of 11 for the resist film and 140 for the SiO₂ film was obtainable as to the selection ratio. Further, an appropriate etching pattern was obtainable up to the width of line/space of the resist film at 0.5 µm. Furthermore, generation of dust was not noticed during etching. With this, stabilized etching can be performed at all times.

### (6) Comparison example

In order to compare the etching method of the present invention with a conventional etching method, a sample same as the sample used in the first to the fifth embodiments was used and etched by a conventional etching method.

The conventional etching conditions are the same etching conditions in the embodiments of the present invention except the etching gas. Namely, the etching conditions are such that the gas pressure in the plasma etching apparatus is at 0.11 Torr, the RF electric power having a frequency of 13.56 MHz is at 250 W (with d.c. bias at 350 V), and the substrate temperature is at 20°C, which are the same as those in the first embodiment. Further, the sample to be etched is similar to that in the first embodiment. On the other hand, gas obtained by mixing Cℓ₂ gas at 50 SCCM, BCℓ₃ gas at 165 SCCM and CHCℓ₃ gas at 15 SCCM is used as the etching gas.

As a result, according to a conventional method, the etching rate of the Aℓ film was at 1.0 µm/min., and the result 3 to 4 for the resist film and 12 to 150 for the SiO₂ film was obtainable as to the selection ratio.

Further, it is up to the width of line/space of the resist film at 0.9 µm at most that an appropriate etching pattern of an Aℓ film is obtainable.

As described above, according to respective embodiments of the present invention, generation of dust during etching of Aℓ is very little. Therefore, stabilized etching becomes possible, and the etching rate of the Aℓ film is equivalent to or higher than a conventional method, thus causing no problem in practical application.

Further, the selection ratio of one of the SiO₂ film and the resist film to one of aluminum and aluminum alloy is also larger as compared with a conventional example. Furthermore, an appropriate etching pattern of an Aℓ film is obtainable up to a narrower width at 0.5 µm of line/space as compared with the past is obtainable.

As described above, according to a method of plasma dry etching of the present invention, side etching is very little. Therefore, it becomes possible to perform patterning of aluminum and aluminum alloy with high accuracy. With this, it becomes possible to manufacture a highly integrated and very fine semiconductor device.

Further, since generation of dust during etching is very little, it is possible to prevent contamination of wafers and the inside of an etching apparatus. Thus, the manufacturing process is stabilized, and it becomes possible to manufacture a highly reliable semiconductor device. Furthermore, it is possible to aim at improvement of the throughput of production since the etching rate is also high.

## Claims

1. A method for manufacturing a semiconductor device characterized in that one of aluminum and aluminum alloy is etched by gas obtained by mixing gas of Cℓ₂ interrelated group and gas of bromine interrelated group.

2. A method for manufacturing a semiconductor device characterized in that one of aluminum and aluminum alloy is etched by mixed gas of Cℓ₂, BCℓ₃ and HBr.

3. A method for manufacturing a semiconductor device characterized in that one of aluminum and aluminum alloy is etched by mixed gas of Cℓ₂, BCℓ₃ and BBr₃.

4. A method for manufacturing a semiconductor device characterized in that one of aluminum and aluminum alloy is etched by mixed gas of Cℓ₂ and BBr₃.

5. A method for manufacturing a semiconductor device characterized in that one of aluminum and aluminum alloy is etched by mixed gas of BCℓ₃ and HBr.

6. A method for manufacturing a semiconductor device characterized in that one of aluminum and aluminum alloy is etched by mixed gas of HBr and BBr₃.
